# EUROPEAN PATENT APPLICATION

(11) **EP 3 540 472 A1**
(43) Date of publication of application: **18.09.2019**
(21) Application number: 19156569.6
(22) Date of filing: 12.02.2019
(51) Int. Cl.: G01V 8/12, G01D 11/24, G01S 7/481, H01L 31/0203

(54) **PHOTOELECTRIC SENSOR**

(30) Priority: 15.03.2018 JP 2018048030
(71) Applicant: OMRON Corporation, Shiokoji-dori, Shimogyo-Ku Kyoto-shi Kyoto 600-8530 (JP)
(72) Inventor: MIZUSAKI, Hiroyuki, Kyoto-shi Kyoto 600-8530 (JP); NAKAMURA, Jumpei, Kyoto-shi Kyoto 600-8530 (JP); TSUJI, Tomohiro, Kyoto-shi Kyoto 600-8530 (JP); SUGIMOTO, Makoto, Kyoto-shi Kyoto 600-8530 (JP)
(74) Representative: Becker Kurig Straus

(57) **Abstract**

A photoelectric sensor (100) includes a substrate (20) on which at least one of the light emitting unit and the light receiving unit is mounted, and a cover portion having a protective portion (10) facing the substrate (20) and protecting the substrate (20), and a side wall (11) extending from the protective portion (10) toward the substrate (20) side, in which the side wall (11) of the cover portion includes a first portion (12) formed in a first width and a second portion (13) formed in a second width smaller than the first width, the first portion (12) is positioned between the protective portion (10) and the second portion (13), a surface (21a) in an end portion (21) of the substrate (20) is in contact with the first portion (12), and a side surface (21b) in the end portion (21) of the substrate (20) faces the second portion (13).

## Description

### BACKGROUND

### Technical Field

The disclosure relates to a photoelectric sensor.

### Description of Related Art

Conventionally, a photoelectric sensor is used to detect the presence or absence of an object in a detection region (for example, Patent Document 1 or the like). In photoelectric sensors, there is a transmission-type sensor having a light emitting unit for emitting light and a light receiving unit for detecting light which are housed in separate housings and configured such that light emitted from one photoelectric sensor is received by the other photoelectric sensor. When an object is present between the light emitting unit and the light receiving unit, light is blocked and an amount of light received by the light receiving unit decreases. The transmission-type sensor detects the presence or absence of an object by measuring the decrement. In photoelectric sensors, there is also a reflection-type sensor having a light emitting unit and a light receiving unit which are housed in an integrated housing and configured to detect the presence or absence of an object or the like by reflecting light on the object and measuring the reflected light.

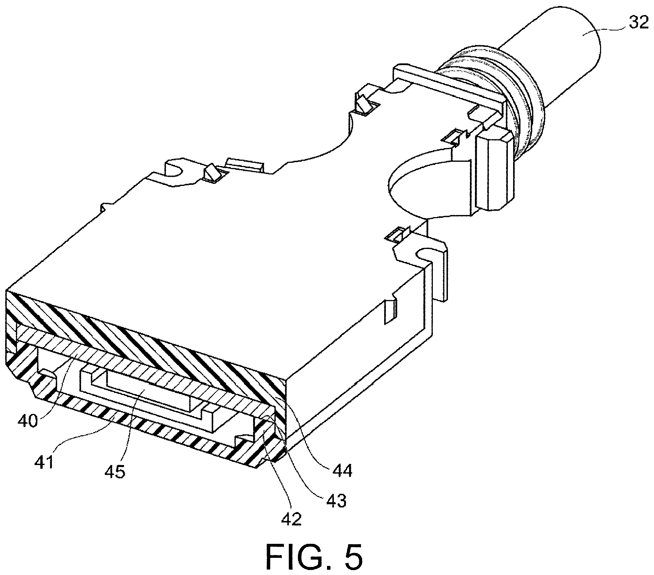

The light emitting unit and the light receiving unit are each configured by optical elements such as a light emitting diode or a photodiode, and are mounted on a substrate inside the housing. In order to seal these optical elements, after disposing the substrate inside the housing, a sealing member such as a resin may be filled into the inside of the housing. However, when the sealing member adheres to the optical elements, since an amount of light emitted and received by an optical element decreases, there is a likelihood that object detection will not be accurately performed. Therefore, as illustrated in FIG. 5, a cover constituted by a protective portion 41 and a side wall 42 is made to cover a substrate 40 to prevent a sealing member 44 from adhering to an optical element 45. In a sealing process, an end surface 43 of the side wall 42 is adhered to the substrate 40 with an adhesive so that the sealing member 44 does not flow from a space between the substrate 40 and the side wall 42.

### Patent Documents

[Patent Document 1] Japanese Laid-open No. 2014-107698

### SUMMARY

However, in the above-described method of adhering the entire region of the end surface 43 of the side wall 42 to the substrate 40, it is difficult to secure a large mounting region on the substrate. Therefore, it is difficult to mount large-size packaged components or the like on the substrate.

Accordingly, it is an objective of the disclosure to provide a photoelectric sensor in which a large mounting region can be secured on a substrate.

A photoelectric sensor according to one aspect of the disclosure is a photoelectric sensor having at least any one of a light emitting unit that emits light and a light receiving unit that detects light, and the photoelectric sensor includes a substrate on which at least any one of the light emitting unit and the light receiving unit is mounted, and a cover portion including a protective portion facing the substrate and configured to protect the substrate and a side wall extending from a peripheral edge of the protective portion toward the substrate side, in which the side wall of the cover portion includes a first portion formed in a first width, and a second portion formed in a second width smaller than the first width, the first portion is positioned between the protective portion and the second portion, a surface in an end portion of the substrate is in contact with the first portion, and a side surface in the end portion of the substrate faces the second portion.

According to this aspect, since a sealing member can be prevented from flowing into a space between the substrate and the cover portion without bringing the entire region of the end surface of the side wall into contact with the surface of the substrate, a component mounting region can be largely secured on the substrate. Therefore, large-size components such as packaged electronic components can be mounted on the substrate.

In the above aspect, the side surface in the end portion of the substrate may be in contact with the side wall.

According to this aspect, a contact area between the end portion of the substrate and the side wall of the cover portion can be increased, and it is possible to more reliably prevent the sealing member from entering a hollow region provided between the substrate and the cover portion. Further, since the side surface of the substrate is in contact with the inner wall of the second portion, positioning of the substrate with respect to the cover portion can be accurately performed at the time of assembly.

In the above aspect, an integrated circuit (IC) package may be mounted on the substrate.

According to this aspect, components such as optical elements included in the photoelectric sensor are mounted on the substrate in a packaged state. Therefore, the optical elements can be protected from an external impact, humidity, heat, or the like.

In the above aspect, a lens may be formed in the protective portion.

According to this aspect, since the lens is formed in the protective portion, there is no need to secure a region for mounting a lens on the substrate. Therefore, a space for mounting components other than lens can be largely secured, and a larger component can be mounted on the substrate.

According to the disclosure, it is possible to provide a photoelectric sensor in which a large mounting region can be secured on a substrate.

### BRIEF DESCRIPTION OF THE DRAWINGS

FIG. 1 is a perspective view of a photoelectric sensor according to a first embodiment of the disclosure.
FIG. 2 is a cross-sectional view of the photoelectric sensor according to the first embodiment of the disclosure.
FIG. 3 is an enlarged cross-sectional view of the photoelectric sensor according to the first embodiment of the disclosure.
FIG. 4 is an enlarged cross-sectional view of a photoelectric sensor according to a second embodiment of the disclosure.
FIG. 5 is a cross-sectional view of a conventional photoelectric sensor.

### DESCRIPTION OF THE EMBODIMENTS

Embodiments of the disclosure will be described with reference to the accompanying drawings. In each of the drawings, the same reference signs are given to the same or similar components.

### [First embodiment]

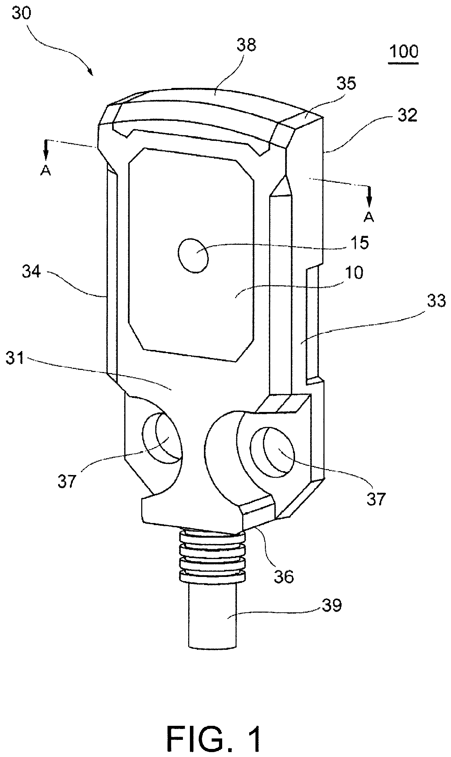

FIG. 1 is a perspective view of a photoelectric sensor 100 according to a first embodiment of the disclosure. A photoelectric sensor detects the presence or absence of an object in a detection region, a surface state of an object, or the like using light. There are a plurality of detection methods using photoelectric sensors. For example, two photoelectric sensors may be prepared, one photoelectric sensor may be used as a light emitter for emitting light, and the other photoelectric sensor may be used as a light receiver for detecting light. When an object is present between the light emitter and the light receiver, an amount of light received by the light receiver decreases. The photoelectric sensor measures the decrement to detect the presence or absence of an object. The photoelectric sensor used in this detection method is called a transmission-type sensor.

Further, as another detection method, there is also a method of performing detection using a photoelectric sensor in which a light emitter and a light receiver are integrated. Light from a photoelectric sensor is emitted toward a reflection plate, a detection object, or the like, and the same photoelectric sensor receives and measures the reflected light, thereby detecting the presence or absence of an object. Such a photoelectric sensor which functions as both a light emitter and a light receiver is called a reflection-type sensor.

With reference to FIG. 1, a configuration of the photoelectric sensor 100 will be described. In the present specification, the photoelectric sensor 100 operating as a light receiver among the photoelectric sensors of transmission-type will be described as an example, but photoelectric sensors to which the disclosure is applied may be a photoelectric sensor operating as a light emitter or a photoelectric sensor of a reflection-type. The photoelectric sensor 100 includes a housing 30, a protective portion 10, a window 38, and a cable 39. Further, a light receiving lens 15 is formed in the protective portion 10.

The housing 30 protects various components such as a light receiving element contained in the photoelectric sensor 100 from an impact or contamination from the outside. The housing 30 is made of a metal or a resin, for example. The housing 30 has a front surface 31, a back surface 32, a side surface 33, a side surface 34, a top surface 35, and a bottom surface 36. A surface on which light from a detection region is incident is the front surface 31, and the back surface 32 is positioned to face the front surface 31 with the inside of the housing 30 interposed therebetween. Further, the side surface 33 and the side surface 34 are positioned to face each other with the inside of the housing 30 interposed therebetween. Similarly, the top surface 35 and the bottom surface 36 are also positioned to face each other with the inside of the housing 30 interposed therebetween.

A mounting hole 37 is provided in the housing 30, and a screw or the like can be inserted into the mounting hole 37 to fix the photoelectric sensor 100 to a wall, a floor surface, a ceiling, or the like. A distance between the front surface 31 and the back surface 32 is configured to be smaller than a distance between the side surface 33 and the side surface 34 so that a thickness of the photoelectric sensor 100 in a side view becomes small. Therefore, even when a space for mounting the photoelectric sensor 100 is narrow, the photoelectric sensor 100 can easily be installed. Further, a distance between the front surface 31 and the back surface 32 is not necessarily smaller than a distance between the side surface 33 and the side surface 34.

A part or all of a light receiving unit is housed inside the housing 30. The light receiving unit is a portion that detects light incident from a detection region, and includes a light receiving element and the light receiving lens 15. The light receiving element may be, for example, a photodiode or a position detecting element. The light receiving lens 15 is a lens that causes light incident from the detection region to form an image on the light receiving element. The light receiving lens 15 may be housed inside the housing 30, or may be formed in the protective portion 10 as illustrated in FIG. 1 while being partially exposed to the outside of the housing 30. When a lens is formed in the protective portion 10 as in this example, there is no need to secure a region for mounting a lens on the substrate. Therefore, a mounting space for components other than the lens can be largely secured, and a larger component can be mounted on the substrate.

Further, a photoelectric sensor operating as a light emitter includes a light emitting unit for emitting light, and the light emitting unit is constituted by a light emitting element, a light emitting lens, and the like. The light emitting element may be, for example, a light emitting diode (LED) or the like. The light emitting lens may be housed inside the housing, or may be formed integrally with the protective portion while being partially exposed to the outside of the housing as in the photoelectric sensor 100 illustrated in FIG. 1.

The protective portion 10 protects components such as the light receiving element housed in the photoelectric sensor 100. Since the protective portion 10 is disposed on a surface receiving light incident from a detection region, the protective portion 10 is formed of a material that transmits light so that the light receiving element positioned inside the photoelectric sensor 100 can detect the light. For example, the protective portion 10 may be formed of a resin or the like. Further, the entire protective portion 10 need not be formed of a material that transmits light and, for example, only the light receiving lens 15 may be formed of a member that transmits light so that the light receiving element detects light through the light receiving lens 15.

The window 38 protects an indicator (not illustrated) provided on an upper portion of the photoelectric sensor 100 from an impact or contamination. The indicator displays a power supply status, detection status, or the like of the photoelectric sensor 100. The indicator may be configured by light emitting elements such as a light emitting diode, for example. The indicator may be lit when a power supply of the photoelectric sensor 100 is turned on or when the photoelectric sensor 100 detects an object. Further, the indicator may be lit using light of different colors according to types of objects detected by the photoelectric sensor 100.

The cable 39 transmits electric power supplied from a power supply to the photoelectric sensor 100. Also, the cable 39 can connect the photoelectric sensor 100 to an amplifier unit including an amplifier unit, a control unit, or the like to transmit detection results obtained by the photoelectric sensor 100. In the present example, the cable 39 is connected to the bottom surface 36 of the photoelectric sensor 100, but the connecting position is not necessarily the bottom surface 36 and it may be connected to the side surface 33, the side surface 34, the top surface 35 or the like. At least any one of the power supply and the amplifier unit may be incorporated in the photoelectric sensor 100.

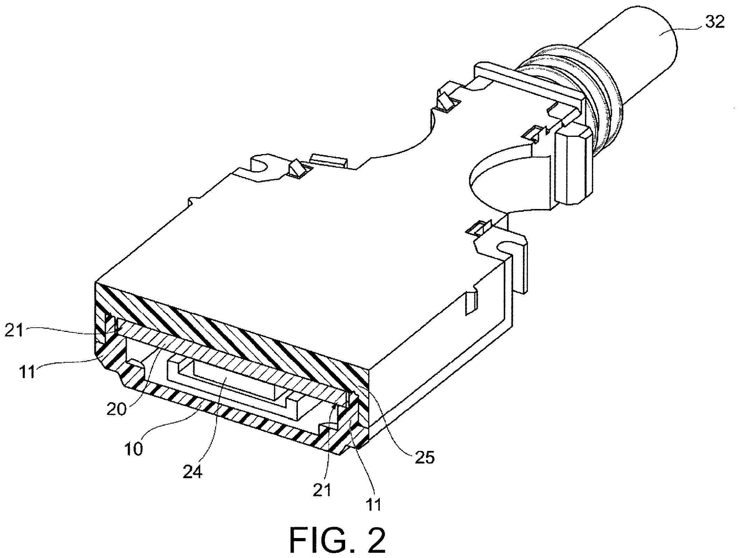

FIG. 2 is a cross-sectional view of the photoelectric sensor 100 according to the first embodiment of the disclosure and illustrates a cross section taken along line A-A of FIG. 1. With reference to FIG. 2, an internal configuration of the photoelectric sensor 100 according to the present embodiment will be described. FIG. 2 is a view illustrating an inside of the housing 30.

The photoelectric sensor 100 includes a cover portion (protective portion 10 and side wall 11), a substrate 20, and a sealing member 25. The substrate 20 is positioned to be sandwiched between the protective portion 10 and the sealing member 25. On the substrate 20, a light receiving element 24 is mounted.

The cover portion includes the protective portion 10 and the side wall 11. The protective portion 10 is positioned to face the substrate 20. The side wall 11 extends from a peripheral edge of the protective portion 10 toward the substrate 20 side. The protective portion 10 and the side wall 11 may be integrally formed as the same member or may be formed as different members.

In a sealing process, the side wall 11 prevents the sealing member 25 from flowing into a hollow region provided between the substrate 20 and the protective portion 10. An end portion of the side wall 11 is recessed inside so that it is formed in an L-shape in a cross-sectional view.

The light receiving element 24 such as a photodiode is mounted on the substrate 20. An end portion 21 of the substrate 20 is positioned to be in contact with a part of the L-shaped recess formed in the side wall 11. A hollow region is provided between the substrate 20 and the protective portion 10, and the light receiving element 24 or the like mounted on the substrate 20 is housed in the hollow region. By housing the light receiving element 24 in the hollow region, a heat-shock to the light receiving element 24 can be alleviated and failure of the photoelectric sensor 100 can be prevented. Further, arbitrary components such as a light receiving lens, an integrated circuit (IC) package, and the like may be mounted on the substrate 20.

The sealing member 25 seals internal components such as the light receiving element 24 mounted on the substrate 20. Sealing with the sealing member 25 is performed by disposing the cover portion, the substrate 20, and the like in a sealing mold and then pouring a heated sealing member 25 into the sealing mold. By sealing with the sealing member 25, it is possible to protect the internal components from moisture, dust, or the like. The sealing member 25 may be, for example, a resin such as a hot-melt resin.

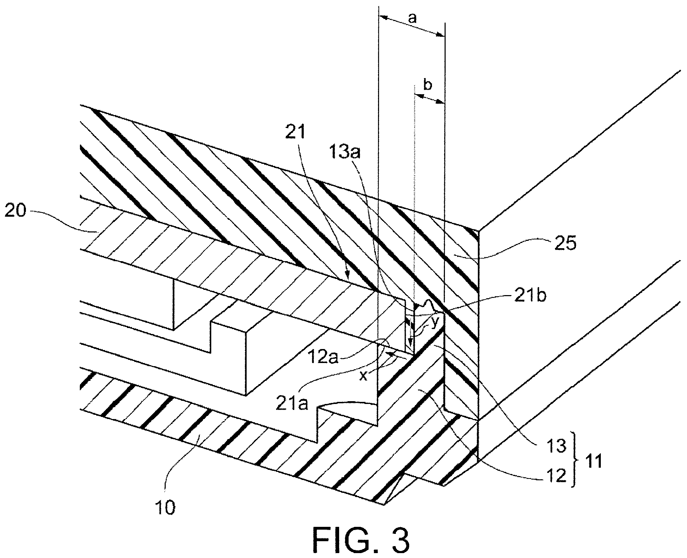

FIG. 3 is an enlarged view of the side wall 11 and the end portion 21 of the substrate 20 in the cross section of the photoelectric sensor 100 according to the first embodiment of the disclosure.

The side wall 11 includes a first portion 12 having a first width a and a second portion 13 having a second width b smaller than the first width a. The first portion 12 is positioned between the protective portion 10 and the second portion 13. The second portion 13 extends in a direction away from the protective portion 10 from a region on an outer side of an end surface 12a of the first portion 12. The end surface 12a of the first portion 12 and an inner wall 13a of the second portion 13 form an L-shaped recess in a cross-sectional view.

A positional relationship between the end portion 21 of the substrate 20 and the L-shaped recess will be described. The end portion 21 of the substrate 20 includes a front surface 21a and a side surface 21b. Here, the surface 21a does not refer to the entire surface of the substrate 20, and refers to a peripheral edge portion in the surface region of the substrate 20. When the substrate 20 and the cover portion are combined, the surface 21a is in contact with the end surface 12a of the first portion 12. Further, the side surface 21b is positioned to face the inner wall 13a of the second portion 13, and a gap is provided between the side surface 21b and the inner wall 13a.

Next, sealing by the sealing member 25 will be described. As described above, sealing with the sealing member 25 is performed by disposing the cover portion, the substrate 20, and the like in a sealing mold and then pouring a heated sealing member 25 into the sealing mold. When the sealing member 25 is poured into the sealing mold, the sealing member 25 enters the gap provided between the side surface 21b and the inner wall 13a. At this time, a direction in which the sealing member 25 flows is restricted only in a y direction (downward direction in FIG. 3) by the side surface 21b and the inner wall 13a. Therefore, the sealing member 25 does not move in an x direction along the surface 21a (the direction from the outside to the inside of the side wall 11), and the sealing member 25 does not flow into the hollow region from a space between the surface 21a and the end surface 12a.

According to the photoelectric sensor 100 of the present embodiment, since the sealing member 25 can be prevented from flowing into a space between the substrate 20 and the cover portion without bringing the entire region of the end surface of the side wall 11 into contact with the surface of the substrate 20, a component mounting region can be largely secured on the substrate 20. Therefore, large-sized components such as packaged electronic components can be mounted on the substrate 20. Also, since it is not necessary to bond the substrate 20 and the cover portion with an adhesive to prevent the sealing member 25 from entering the hollow region, a manufacturing efficiency of the photoelectric sensor 100 can be improved.

Further, according to the photoelectric sensor 100 of the present embodiment, since a component mounting region can be largely secured on the substrate 20, large IC packages, modules, or the like can be mounted on the substrate 20. For example, an optical element such as the light receiving element 24 can be mounted on the substrate 20 in a packaged state, and the optical element can be protected from an external impact, humidity, heat, or the like.

### [Second Embodiment]

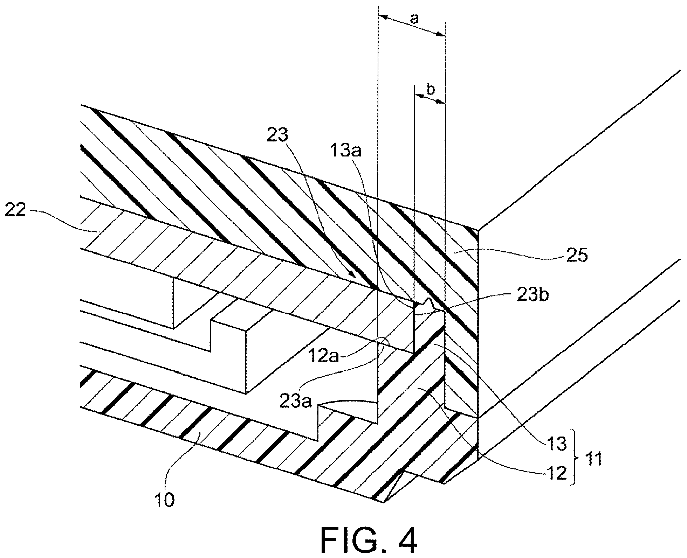

FIG. 4 is an enlarged view of an end portion of a substrate 22 in a cross section of a photoelectric sensor according to a second embodiment of the disclosure. The photoelectric sensor according to the second embodiment is different from the photoelectric sensor 100 according to the first embodiment in that a side surface 23b of the substrate 22 and an inner wall 13a of a second portion 13 are in contact with each other. Regarding other configurations, the photoelectric sensor according to the present embodiment has the same configuration as the photoelectric sensor 100 according to the first embodiment.

An end portion 23 of the substrate 22 has a surface 23a and the side surface 23b. Here, as in the surface 21a according to the first embodiment, the surface 23a does not refer to the entire surface of the substrate 22, and refers to a peripheral edge portion in the surface region of the substrate 22. When the substrate 22 and a cover portion are combined, the surface 23a is in contact with an end surface 12a of a first portion 12. Further, the side surface 23b is in contact with the inner wall 13a of the second portion 13, and in this embodiment, they are in surface contact with each other.

According to this aspect, a contact area between the end portion 23 of the substrate 22 and a side wall 11 of the cover portion can be increased. Therefore, in a sealing process, it is possible to more reliably prevent a sealing member 25 from entering a hollow region from a space between the substrate 20 and the cover portion. Further, since the side surface 23b of the substrate 22 is in contact with the inner wall 13a of the second portion 13, positioning of the substrate 22 with respect to the cover portion can be accurately performed at the time of assembly.

The embodiments described above are for facilitating understanding of the disclosure and are not intended to limit the disclosure. The elements and, an arrangement, a material, conditions, a shape, a size, and the like thereof of the embodiments are not limited to those exemplified and can be appropriately changed. Further, configurations illustrated in the different embodiments can be partially substituted or combined.

### (Additional note)

A photoelectric sensor 100 having at least any one of a light emitting unit that emits light and a light receiving unit that detects light includes a substrate 20 on which at least any one of the light emitting unit and the light receiving unit is mounted, and a cover portion having a protective portion 10 facing the substrate 20 and configured to protect the substrate 20, and a side wall 1 1 extending from a peripheral edge of the protective portion 10 toward the substrate 20 side, in which the side wall 11 of the cover portion includes a first portion 12 formed in a first width and a second portion 13 formed in a second width smaller than the first width, the first portion 12 is positioned between the protective portion 10 and the second portion 13, a surface 21a in an end portion 21 of the substrate 20 is in contact with the first portion 12, and a side surface 21b in the end portion 21 of the substrate 20 faces the second portion 13.

### [Reference Signs List]

10 Protective portion
11 Side wall
12 First portion
12a End surface
13 Second portion
13a Inner wall
15 Light receiving lens
20 Substrate
21 End portion
21a Surface
21b Side surface
22 Substrate
23 End portion
23a Surface
23b Side surface
24 Light receiving element
25 Sealing member
30 Housing
31 Front surface
32 Back surface
33 Side surface
34 Side surface
35 Top surface
36 Bottom surface
37 Mounting hole
38 Window
39 Cable
40 Substrate
41 Protective portion
42 Side wall
43 End surface
44 Sealing member
45 Optical element
100 Photoelectric sensor

## Claims

1. A photoelectric sensor (100) having at least any one of a light emitting unit that emits light and a light receiving unit that detects light, the photoelectric sensor (100) **characterized in that** comprising:
a substrate (20) on which at least any one of the light emitting unit and the light receiving unit is mounted; and
a cover portion including:
a protective portion (10) facing the substrate (20) and configured to protect the substrate (20); and
a side wall (11) extending from a peripheral edge of the protective portion (10) toward the substrate (20) side, wherein
the side wall (11) of the cover portion includes:
a first portion (12) formed in a first width; and
a second portion (13) formed in a second width smaller than the first width,
the first portion (12) is positioned between the protective portion (10) and the second portion (13),
a surface (21a) in an end portion (21) of the substrate (20) is in contact with the first portion (12), and
a side surface (21b) in the end portion (21) of the substrate (20) faces the second portion (13).

2. The photoelectric sensor (100) according to claim 1, wherein the side surface (21b) in the end portion (21) of the substrate (20) is in contact with the side wall (11).

3. The photoelectric sensor (100) according to claim 1 or 2, wherein an integrated circuit package is mounted on the substrate (20).

4. The photoelectric sensor (100) according to any one of claims 1 to 3, wherein a lens (15) is formed in the protective portion (10).
